# EUROPEAN PATENT APPLICATION

(11) **EP 4 707 074 A1**
(43) Date of publication of application: **11.03.2026**
(21) Application number: 24814229.1
(22) Date of filing: 20.05.2024
(51) Int. Cl.: B60R 1/12, B60R 1/04, B60R 11/02

(54) **IMPACT-RESISTANT REARVIEW MIRROR**

(30) Priority: 29.05.2023 CN 202321336814 U
(71) Applicant: YFORE Technology Co., Ltd., Dongguan, Guangdong 523808 (CN)
(72) Inventor: WANG, Fangde, Dongguan, Guangdong 523808 (CN); QIN, Jiayong, Dongguan, Guangdong 523808 (CN); ZHU, Jingbao, Dongguan, Guangdong 523808 (CN)
(74) Representative: Petraz, Gilberto Luigi
(86) International application number: PCT/CN2024/094229
(87) International publication number: WO 2024/245030

(57) **Abstract**

An impact-resistant rearview mirror includes a housing (10), a display module (30), a reflective mirror (20), and a mounting bracket (40), where the housing (10) includes a front housing (11) and a rear housing (12) that are mutually matched, a rear side of the display module (30) is a heat dissipation plate (33), a front side is a display screen (31), the mounting bracket (40) includes a base (42) and a support plate (41) that is supportingly connected to the base (42), the display module (30) and the support plate (41) are installed in the housing (10), the heat dissipation plate (33) is fixedly connected to the support plate (41) and causes the support plate (41) to support the heat dissipation plate (33), the reflective mirror (20) is installed on the front housing (11) and located on a front side of the display screen (31), and an inner side surface of the reflective mirror (20) and an outer surface of the display screen (31) are pasted together via an adhesive layer (21). When an external force impacts the reflective mirror (20), the force may be transmitted from the display module (31) to the base (42), preventing the reflective mirror (20) from deforming and breaking due to impact.

## Description

This application claims priority to Chinese Patent Application No. 202321336814.3, entitled "Impact-Resistant Rearview Mirror", filed with the China National Intellectual Property Administration on May 29, 2023, the entire contents of which are incorporated herein by reference.

### TECHNICAL FIELD

The present application relates to a vehicle-mounted device, and more particularly to an impact-resistant rearview mirror.

### BACKGROUND

Rearview mirrors are located on left and right sides of the front of a vehicle, and at the front inside the vehicle. Rearview mirrors reflect situations behind, beside, and below the vehicle, allowing the driver to indirectly see these areas, functioning as a "second eye" to expand the driver's field of vision. With technological development, rearview mirrors installed inside the vehicle are commonly equipped with a motorized mirror surface. Such rearview mirrors with a motorized mirror surface may provide dual functions: they may serve as ordinary reflective mirrors to reflect strong light from vehicles behind, and as electronic display screens to display images of rear vehicles via the electronic display screen.

Referring to Chinese Patent CN113844366A, conventional rearview mirrors generally include a housing, a reflective mirror mounted on the housing, a display module installed inside the housing, and a base, where a support bracket of the base is installed inside the housing and supports the entire lens portion (reflective mirror and display module) of the rearview mirror. However, in conventional rearview mirrors, there is generally a certain gap (1.2 mm) between the reflective mirror and the display screen of the display module, causing the reflective mirror to be in a suspended state within the window area of the housing. When a pendulum ball impacts the front glass surface of the reflective mirror in a CCC head impact test, the glass bends and deforms backward. Since glass material has poor toughness, the glass exceeds its yield strength during deformation, causing the surface glass of the reflective mirror to shatter and splinter.

Therefore, there is an urgent need for a rearview mirror that may solve the above problems.

### SUMMARY

### Technical Problem

One of the objectives of the embodiments of the present application is to provide an impact-resistant rearview mirror, an external force may be transmitted from the display module to the base through force conduction when the force impacts the reflective mirror, preventing the surface glass of the reflective mirror from deforming and breaking due to impact, and having strong impact resistance.

### Technical Solution

To solve the above technical problem, the technical solution adopted in the embodiments of the present application is:
Provided in an embodiment of the present application is an impact-resistant rearview mirror, including a housing, a display module, a reflective mirror, and a mounting bracket, where the housing includes a front housing and a rear housing that are mutually matched, a rear side of the display module is a heat dissipation plate, a front side is a display screen, the mounting bracket includes a base and a support plate that is supportingly connected to the base, the display module and the support plate are installed in the housing, the heat dissipation plate is fixedly connected to the support plate and causes the support plate to support the heat dissipation plate, the reflective mirror is installed on the front housing and located on a front side of the display screen, and an inner side surface of the reflective mirror and an outer surface of the display screen are pasted together via an adhesive layer.

In an embodiment, the front housing includes a middle housing plate and a front housing side wall, a front accommodation cavity is formed between the middle housing plate and the front housing side wall, the display module is installed in the front accommodation cavity and causes the heat dissipation plate to be fixed to the middle housing plate, the support plate is installed in a rear accommodation cavity formed between the rear housing and the middle housing plate, the support plate is fixed to the middle housing plate to support the middle housing plate, and causes the middle housing plate to be clamped between the support plate and the heat dissipation plate, the reflective mirror is installed on the front housing and located on a front side of the front accommodation cavity. This solution enables the front housing to be fixed together with the display module and the support plate through the middle housing plate, preventing excessive deformation between the periphery and the center of the reflective mirror when impacted.

In an embodiment, the front housing includes a front housing side wall, a front end of the front housing side wall forms a mounting platform for the reflective mirror, the display module is installed in the housing and causes an outer surface of the display screen to protrude to the mounting platform, a periphery of the reflective mirror is installed on the mounting platform. This solution enables the reflective mirror to be installed on the front housing from the front side of the front housing, not only facilitating installation but also causing the periphery of the reflective mirror to be supported by the front housing and the central window area to be supported by the display module, achieving full support.

In an embodiment, the front housing includes a middle housing plate and a front housing side wall, a front accommodation cavity is formed between the middle housing plate and the front housing side wall, a front end of the front housing side wall forms a mounting platform for the reflective mirror, the display module is installed in the front accommodation cavity and causes an outer surface of the display screen to protrude to the mounting platform, a periphery of the reflective mirror is installed on the mounting platform. This solution enables the reflective mirror to be installed on the front housing from the front side of the front housing, not only facilitating installation but also causing the periphery of the reflective mirror to be supported by the front housing and the central window area to be supported by the display module, achieving full support. Furthermore, this solution also causes the impact force received by the reflective mirror to be supported and dissipated through two parts: the display module-support plate and the front housing-middle housing plate-support plate, preventing the display module from being damaged due to bearing the entire impact force.

In an embodiment, the reflective mirror is installed on the mounting platform and covers a front end surface of the front housing side wall, and a smooth curve or straight line is formed between a side surface of the reflective mirror and the front housing side wall. This solution causes the border housing of the front housing of the reflective mirror to be obscured by the reflective mirror, achieving a borderless structure for the rearview mirror.

In an embodiment, the heat dissipation plate, the middle housing plate, and the support plate are respectively provided with correspondingly positioned screw holes, through holes, and mounting holes, screws sequentially pass through the mounting holes of the support plate, the through holes on the middle housing plate, and the screw holes on the heat dissipation plate to fix the middle housing plate, the heat dissipation plate, and the support plate together. This solution enables the middle housing plate, the heat dissipation plate, and the support plate to be fixed together by one screw at the same mounting hole, with a consistent force application point, making the installation structure of the rearview mirror stable, and preventing the three from twisting and deforming due to different force application points during impact.

In an embodiment, the front side surface of the middle housing plate is provided with a spacing block surrounding each of the through holes, the plate surface of the heat dissipation plate abuts against the spacing block so that the plate surface of the heat dissipation plate and the plate surface of the middle housing plate are spaced apart to facilitate the heat dissipation plate to dissipate heat.

In an embodiment, the front side surface of the middle housing plate is provided with a positioning groove, the rear side surface of the heat dissipation plate is provided with a positioning boss configured to engage with the positioning groove, the positioning boss is configured to fit into the positioning groove when the heat dissipation plate, the middle housing plate, and the support plate are fixed. This solution enables the heat dissipation plate and the middle housing plate to be positioned at multiple points, ensuring high connection stability between the display module and the middle housing plate.

In an embodiment, the rear side surface of the heat dissipation plate is provided with a mounting boss that extends into each of the through holes, each of the screw holes is located in a middle of the mounting boss, the mounting boss is positioned to extend into each of the through holes when the heat dissipation plate, the middle housing plate, the circuit board, and the support plate are fixed, the screws pass through the mounting holes and threadedly connect with the screw holes on the mounting boss, and causes the middle housing plate to be clamped and fixed between the heat dissipation plate and the support plate.

In an embodiment, the impact-resistant rearview mirror further includes a circuit board installed between the middle housing plate and the support plate, the circuit board is provided with an opening corresponding to a position of each of the through holes, the middle housing plate is recessed backward at a position corresponding to each of the mounting holes and is provided with a spacing ring around the recessed position, thereby forming a positioning groove on a front side of the middle housing plate, and forming a spacing boss on the rear side of the middle housing plate, each of the through holes is provided at a bottom of each of the positioning grooves, a rear side surface of the heat dissipation plate is provided with a positioning boss that extends into each of the positioning grooves and a mounting boss that is provided on the positioning boss and extends into each of the through holes and the opening, each of the screw holes is located in a middle of the mounting boss, when the heat dissipation plate, the middle housing plate, the circuit board, and the support plate are fixed, the positioning boss of the heat dissipation plate is positioned to extend into each of the positioning grooves and the mounting boss is positioned to extend into each of the through holes and the opening, and a surface of the spacing boss abuts against the circuit board so that a plate surface of the middle housing plate and the circuit board are spaced apart, the plate surface of the heat dissipation plate abuts against the spacing ring so that the plate surface of the heat dissipation plate and the plate surface of the middle housing plate are spaced apart, the screws pass through the mounting holes and threadedly connect with the screw holes on the mounting boss, and causes the middle housing plate and the circuit board to be clamped and fixed between the heat dissipation plate and the support plate. This solution enables both the heat dissipation plate and the middle housing plate, and the circuit board and the middle housing plate to have spacing, facilitating heat dissipation, and the aforementioned protruding structures also allow the middle housing plate to buffer and dissipate force when the reflective mirror is impacted, and ensure high connection stability between the heat dissipation plate and the middle housing plate.

In an embodiment, the middle housing plate includes a middle portion located at a transverse middle position of the housing, an edge portion connected to front housing side walls on left and right sides of the front housing, and a reinforcement portion spaced between the middle portion and the edge portion, upper and lower sides of the middle portion and the reinforcement portion are respectively connected to front housing side walls on upper and lower sides of the front housing, a heat dissipation space is formed between the edge portion and the reinforcement portion, and a heat dissipation space is formed between the reinforcement portion and the middle portion, thereby providing structural stability without affecting heat dissipation of the internal structure of the rearview mirror. This solution enables the middle housing plate to become a barrier plate, facilitating heat dissipation, and having a certain amount of deformation in both horizontal and vertical directions, making it less prone to breakage.

In an embodiment, a front side of the front housing forms an opening configured to allow the display module to pass through, the display module passes through the opening and is installed in the housing, the reflective mirror is installed on the mounting platform to seal the opening.

In an embodiment, a rear side of the front housing is further provided with a mounting structure configured to engage with the rear housing via a snap-fit connection. The rear side of the front housing is snap-fitted to the rear housing through the mounting structure, forming a rear accommodation cavity between the middle housing plate of the front housing and the rear housing for accommodating the support plate.

In an embodiment, the adhesive layer is an optically clear adhesive, OCA, cured layer or an optically clear resin, OCR, cured layer. Both the OCA cured layer and the OCR cured layer are flexible soft adhesives with certain toughness, which may also act as a buffer between the mirror glass of the reflective mirror and the display screen of the display module. Certainly, other optical solid adhesives or liquid adhesives may also be employed to form the adhesive layer, which is not limited to OCA adhesive and OCR adhesive.

### Technical Effects

The impact-resistant rearview mirror according to the embodiments of the present application achieves the following: by bonding the reflective mirror to the display screen of the display module, and fixedly supporting the heat dissipation plate of the display module with the support plate, a rigid loop is formed among the reflective mirror, the display module, the mounting plate, and the base. An external force may be transmitted from the display module to the base through force conduction when the force impacts the reflective mirror. The rigid loop provides support behind the surface glass of the reflective mirror, preventing the surface glass from deforming and breaking upon impact, thereby enhancing the impact resistance of the rearview mirror.

### BRIEF DESCRIPTION OF THE DRAWINGS

FIG. 1 is a structural view of the rearview mirror according to an embodiment of the present application from one angle;
FIG. 2 is a structural view of the rearview mirror according to an embodiment of the present application from another angle;
FIG. 3 is a cross-sectional view of the rearview mirror according to an embodiment of the present application taken along a center line of a positioning hole;
FIG. 4 is an enlarged view of portion a in FIG. 3;
FIG. 5 is an enlarged view of portion b in FIG. 3;
FIG. 6 is an exploded view of the rearview mirror according to an embodiment of the present application from one angle;
FIG. 7 is a partially exploded view of the rearview mirror according to an embodiment of the present application from another angle;
FIG. 8 is an enlarged view of portions c, d, and e in FIG. 7.

### DETAILED DESCRIPTION

To describe in detail the technical content, structural features, achieved objectives, and effects of the embodiments of the present application, the following explanation is provided in combination with the implementation methods and with reference to the accompanying drawings.

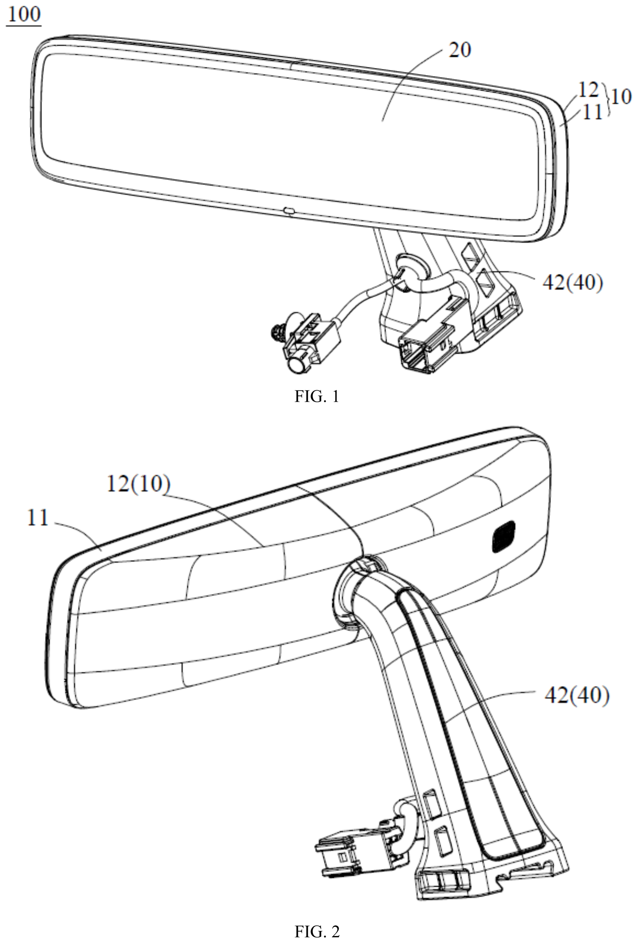

With reference to FIGS. 1 to 7, the embodiment of the present application discloses an impact-resistant rearview mirror 100, including a housing 10, a display module 30, a reflective mirror 20, and a mounting bracket 40, where the housing 10 includes a front housing 11 and a rear housing 12 that are mutually matched, a rear side of the display module 30 is a heat dissipation plate 33, a front side is a display screen 31, the mounting bracket 40 includes a base 42 and a support plate 41 that is supportingly connected to the base 42, the display module 30 and the support plate 41 are installed in the housing 10, the heat dissipation plate 33 is fixedly connected to the support plate 41 and causes the support plate 41 to support the heat dissipation plate 33, the reflective mirror 20 is installed on the front housing 11 and located on a front side of the display screen 31, and an inner side surface of the reflective mirror 20 and an outer surface of the display screen 31 are pasted together via an adhesive layer 21.

The base 42 is installed on a vehicle windshield and passes through the rear housing 12 to be supportingly connected to the support plate 41. In the present embodiment, a front end of the base 42 is provided with a universal ball, and the universal ball is pivotally connected to the support plate 41 and universally connected to the support plate 41 to support the support plate 41. Certainly, the structure of the mounting bracket 40 is not limited to this, and the base 42 may also be connected to and support the support plate 41 through a pivoting assembly or other structures.

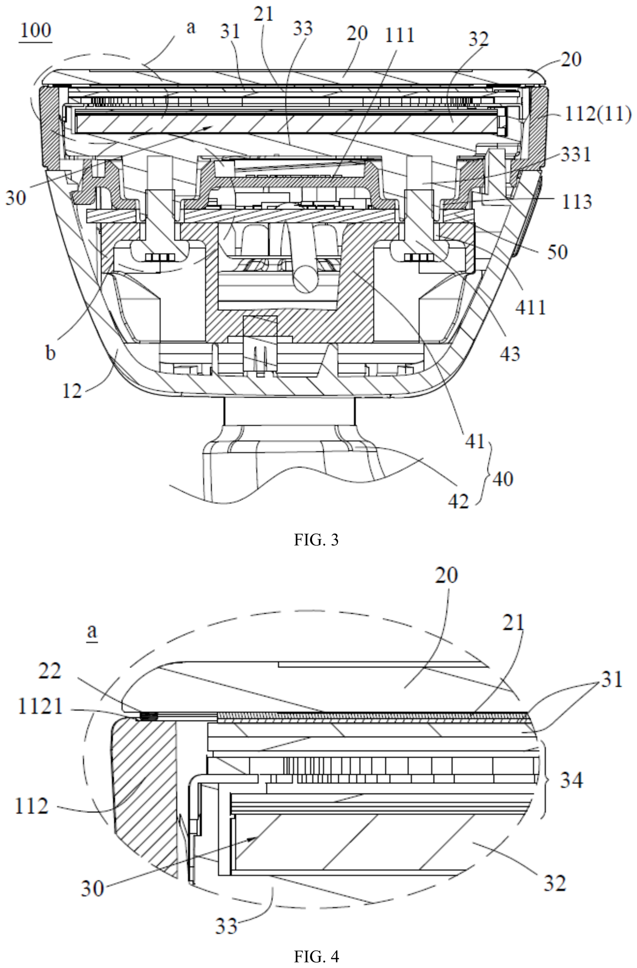

With reference to FIGS. 3 and 4, the adhesive layer 21 is an OCA cured layer, and the OCA cured layer is a glue layer fully covering the outer surface of the display screen 31. In addition to bonding, the OCA cured layer may also act as a buffer between the mirror glass of the reflective mirror 20 and the display screen 31 of the display module 30. Certainly, other optical solid adhesive or liquid adhesive cured layers may also be employed as the adhesive layer 21, such as an OCR cured layer. In the present embodiment, the adhesive layer 21 employs a colloid with good elongation at break to increase the elasticity of the adhesive layer 21.

With reference to FIGS. 3, 6, and 7, the front housing 11 includes a middle housing plate 111 and a front housing side wall 112, a front accommodation chamber is formed between the middle housing plate 111 and the front housing side wall 112, a front side of the front housing 11 forms an opening (the opening of the front accommodation chamber) through which the display module 30 may pass, the display module 30 passes through the opening and is installed in the front accommodation cavity and fixed to the middle housing plate 111, the reflective mirror 20 is installed on the mounting platform 1121 and seals the opening. After the front housing 11 and the rear housing 12 are assembled, a rear accommodation cavity for accommodating the support plate 41 is also formed between the rear housing and the middle housing plate 111.

In an embodiment, the display module 30 is installed in the front accommodation cavity and causes the heat dissipation plate 33 to be fixed to the middle housing plate 111, the support plate 41 is installed in the rear accommodation cavity formed between the rear housing 12 and the middle housing plate 111, the support plate 41 is fixed to the middle housing plate 111 to support the middle housing plate 111, and causes the middle housing plate 111 to be clamped between the support plate 41 and the heat dissipation plate 33, the reflective mirror 20 is installed on the front housing 11 and located on a front side of the front accommodation cavity. The middle housing plate 111 may be directly fixed to the support plate 41 with screws, or the middle housing plate 111 may be clamped and fixed between the support plate 41 and the heat dissipation plate 33 through the support plate 41 and the heat dissipation plate 33, so that the support plate 41 is fixed to the middle housing plate 111 to support the middle housing plate 111.

In the present embodiment, the display module 30 includes a heat dissipation plate 33, a backlight unit 32, an optical unit 34, a display screen 31, and a mounting bracket, and the display screen 31 is an FOG (FPC on glass) display screen. The heat dissipation plate 33 is provided with an installation cavity, the backlight unit 32 and the optical unit 34 are installed in the installation cavity of the heat dissipation plate 33, the mounting bracket is engaged with a snap-fit structure on a side surface of the heat dissipation plate 33, the display screen 31 is installed on the mounting bracket and covers the installation cavity of the heat dissipation plate 33. In the present embodiment, the display screen 31 is pasted on a front side surface of the mounting bracket, so that the mounting bracket fixedly supports the display screen 31. The specific structure of the display module 30 in the rearview mirror is not limited to this and may be other structures, which are well known in the art and will not be described in detail here.

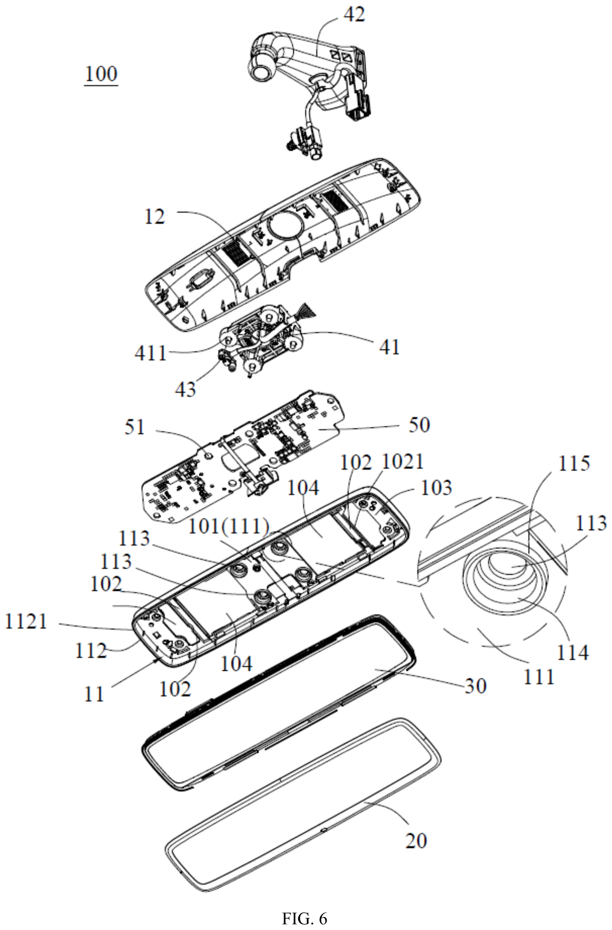

With reference to FIGS. 4 and 6, a front end of the front housing side wall 112 forms a mounting platform 1121 for the reflective mirror 20. The display module 30 is installed in the housing 10 such that an outer surface of the display screen 31 protrudes to the mounting platform 1121, and a periphery of the reflective mirror 20 is installed on the mounting platform 1121. The display module 30 is installed in the front accommodation cavity such that the outer surface of the display screen 31 protrudes to the mounting platform 1121, and the periphery of the reflective mirror 20 is installed on the mounting platform 1121. An inner side of the mounting platform 1121 is recessed in a step shape, and a foam adhesive 22 is provided at a recessed step. The reflective mirror 20 is pasted on the mounting platform 1121 via the foam adhesive 22. Certainly, other adhesive materials may also be employed to paste the reflective mirror 20 onto the front housing side wall 112. Alternatively, the reflective mirror 20 may be installed at other positions on the front housing 11. For example, the front housing side wall 112 of the front housing 11 may be inwardly recessed to form a mounting flange, and the reflective mirror 20 may be installed within this mounting flange. With reference to FIGS. 3 and 4, the reflective mirror 20 is installed on the mounting platform 1121 and covers a front end surface of the front housing side wall 112. A smooth curve or straight line is formed between a side surface of the reflective mirror 20 and the front housing side wall 112, achieving a borderless appearance on the front side of the rearview mirror 100. The side surface of the reflective mirror 20 directly abuts the side surface of the front housing side wall 112, and the front end of the front housing side wall 112 is fully covered and not exposed externally, realizing a borderless installation of the reflective mirror 20.

With reference to FIGS. 3, 5, and 8, the heat dissipation plate 33, the middle housing plate 111, and the support plate 41 are respectively provided with correspondingly positioned screw holes 331, through holes 113, and mounting holes 411. A screw 43 sequentially passes through the mounting hole 411 of the support plate 41, the through hole 113 on the middle housing plate 111, and the screw hole 331 on the heat dissipation plate 33 to fix the middle housing plate 111, the heat dissipation plate 33, and the support plate 41 together. In an embodiment, the screw 43 passes through the mounting hole 411 and is threadedly installed into the screw hole 331 to fix the middle housing plate 111 between the heat dissipation plate 33 and the support plate 41.

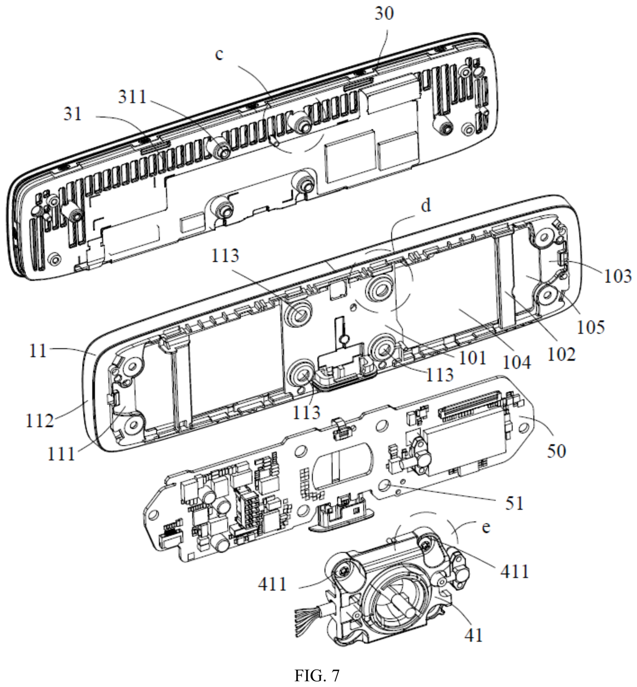

With reference to FIGS. 6 and 7, the middle housing plate 111 includes a middle portion 101 located at a transverse middle position of the housing 10, an edge portion 103 connected to front housing side walls 112 on left and right sides of the front housing 11, and a reinforcement portion 102 spaced between the middle portion 101 and the edge portion 103. Upper and lower sides of the middle portion 101 and the reinforcement portion 102 are respectively connected to front housing side walls 112 on upper and lower sides of the front housing 11. A heat dissipation space 105 is formed between the edge portion 103 and the reinforcement portion 102, and a heat dissipation space 104 is formed between the reinforcement portion 102 and the middle portion 101. The reinforcement portion 102 is provided with a plurality of reinforcement ribs 1021 protruding therefrom. The middle housing plate 111 is also provided with other reinforcement structures. In the present embodiment, the front housing 11 and the rear housing 12 are made of plastic materials, such as ABS and PC materials. Certainly, the materials of the front housing 11 and the rear housing 12 are not limited to this.

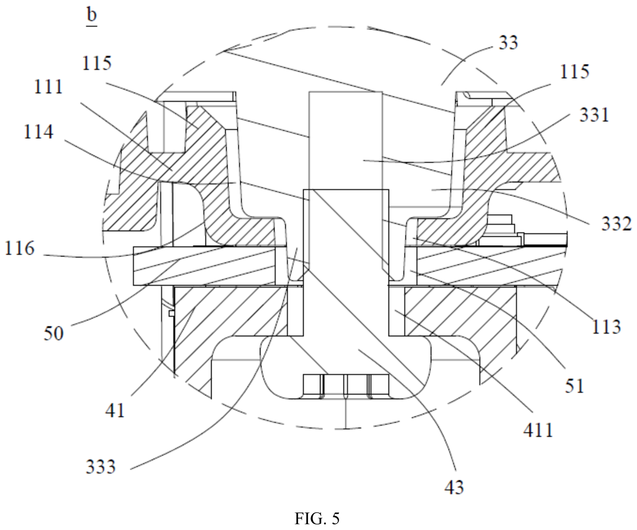

With reference to FIGS. 3 and 5, the impact-resistant rearview mirror 100 further includes a circuit board 50 installed between the middle housing plate 111 and the support plate 41. The circuit board 50 is provided with an opening 51 corresponding to the position of the through hole 113. The screw 43 sequentially passes through the mounting hole 411, the opening 51, and the through hole 113, and is threadedly installed into the screw hole 331 to fix the circuit board 50 and the middle housing plate 111 between the heat dissipation plate 33 and the support plate 41. In the present embodiment, the circuit board 50 is also fixedly connected to the heat dissipation plate 33 by screws passing through corresponding positions of the middle housing plate 111 at locations avoiding the support plate 41, so as to fix both sides of the middle housing plate 111 avoiding the support plate 41 to the heat dissipation plate 33.

With reference to FIGS. 3 and 5, the middle housing plate 111 is recessed backward at a position corresponding to the mounting hole 411 and is provided with a spacing ring 115 protruding around the recess, thereby forming a positioning groove 114 on the front side of the middle housing plate 111 and forming a spacing boss 116 on the rear side of the middle housing plate 111. The through hole 113 is provided at a bottom of the positioning groove 114. The rear side surface of the heat dissipation plate 33 is provided with a positioning boss 332 that extends into the positioning groove 114 and a mounting boss 333 that is provided on the positioning boss 332 and extends into the through hole 113 and the opening 51. The screw hole 331 is located in the middle of the mounting boss 333. When the heat dissipation plate 33, the middle housing plate 111, the circuit board 50, and the support plate 41 are fixed, the positioning boss 332 of the heat dissipation plate 33 is positioned to extend into the positioning groove 114 and the mounting boss 333 is positioned to extend into the through hole 113 and the opening 51, and a surface of the spacing boss 116 abuts against the circuit board 50 so that a plate surface of the middle housing plate 111 and the circuit board 50 are spaced apart, and a plate surface of the heat dissipation plate 33 abuts against the spacing ring 115 so that the plate surface of the heat dissipation plate 33 and the plate surface of the middle housing plate 111 are spaced apart. The screw 43 passes through the mounting hole 411 and threadedly connects with the screw hole 331 on the mounting boss 333, and causes the middle housing plate 111 and the circuit board 50 to be clamped and fixed between the heat dissipation plate 33 and the support plate 41. To facilitate heat dissipation, a high-power heat generation area of the circuit board 50 corresponds to the positions of the heat dissipation space 104 and the heat dissipation space 105.

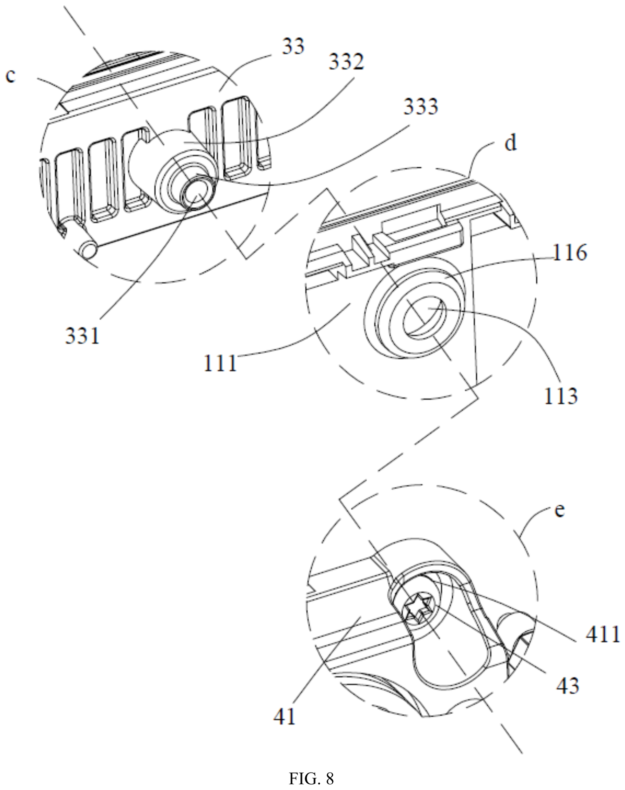

With reference to FIGS. 7 and 8, a rear side of the front housing 11 is further provided with a mounting structure configured to engage with the rear housing 12 via a snap-fit connection. The rear side of the front housing 11 is snap-fitted to the rear housing 12 through the mounting structure, forming a rear accommodation cavity between the middle housing plate 111 of the front housing 11 and the rear housing 12 for accommodating the support plate 41. The mounting structure is provided on a rear side surface of the middle housing plate 111.

The impact-resistant rearview mirror 100 according to the embodiments of the present application achieves the following: by bonding the reflective mirror 20 to the display screen 31 of the display module 30, and fixedly supporting the heat dissipation plate 33 of the display module 30 with the support plate 41, a rigid loop is formed among the reflective mirror 20, the display module 30, the mounting plate, and the base 42. An external force may be transmitted from the display module 30 to the base 42 through force conduction when the force impacts the reflective mirror 20. The rigid loop provides support behind the surface glass of the reflective mirror, preventing the surface glass of the reflective mirror 20 from deforming and breaking upon impact, thereby enhancing the impact resistance of the rearview mirror.

The above applications are only the preferred embodiments of the present application and are not intended to limit the scope of rights of the present application. Therefore, equivalent changes made according to the patent scope of the present application still fall within the scope covered by the present application.

## Claims

1. An impact-resistant rearview mirror, comprising a housing, a display module, a reflective mirror, and a mounting bracket, wherein the housing comprises a front housing and a rear housing that are mutually matched, a rear side of the display module is a heat dissipation plate, a front side is a display screen, the mounting bracket comprises a base and a support plate that is supportingly connected to the base, the display module and the support plate are installed in the housing, the heat dissipation plate is fixedly connected to the support plate and causes the support plate to support the heat dissipation plate, the reflective mirror is installed on the front housing and located on a front side of the display screen, and an inner side surface of the reflective mirror and an outer surface of the display screen are pasted together via an adhesive layer.

2. The impact-resistant rearview mirror according to claim 1, wherein the front housing comprises a middle housing plate and a front housing side wall, a front accommodation cavity is formed between the middle housing plate and the front housing side wall, the display module is installed in the front accommodation cavity and causes the heat dissipation plate to be fixed to the middle housing plate, the support plate is installed in a rear accommodation cavity formed between the rear housing and the middle housing plate, the support plate is fixed to the middle housing plate to support the middle housing plate, and causes the middle housing plate to be clamped between the support plate and the heat dissipation plate, the reflective mirror is installed on the front housing and located on a front side of the front accommodation cavity.

3. The impact-resistant rearview mirror according to claim 1 or 2, wherein the front housing comprises a front housing side wall, a front end of the front housing side wall forms a mounting platform for the reflective mirror, the display module is installed in the housing and causes an outer surface of the display screen to protrude to the mounting platform, a periphery of the reflective mirror is installed on the mounting platform.

4. The impact-resistant rearview mirror according to claim 3, wherein the reflective mirror is installed on the mounting platform and covers a front end surface of the front housing side wall, and a smooth curve or straight line is formed between a side surface of the reflective mirror and the front housing side wall.

5. The impact-resistant rearview mirror according to claim 2, wherein the heat dissipation plate, the middle housing plate, and the support plate are respectively provided with correspondingly positioned screw holes, through holes, and mounting holes, screws sequentially pass through the mounting holes of the support plate, the through holes on the middle housing plate, and the screw holes on the heat dissipation plate to fix the middle housing plate, the heat dissipation plate, and the support plate together.

6. The impact-resistant rearview mirror according to claim 5, wherein a front side surface of the middle housing plate is provided with a spacing block surrounding each of the through holes, a plate surface of the heat dissipation plate abuts against the spacing block so that the plate surface of the heat dissipation plate and the plate surface of the middle housing plate are spaced apart; and/or,
the front side surface of the middle housing plate is provided with a positioning groove, a rear side surface of the heat dissipation plate is provided with a positioning boss configured to engage with the positioning groove, the positioning boss is configured to fit into the positioning groove when the heat dissipation plate, the middle housing plate, and the support plate are fixed; and/or,
the rear side surface of the heat dissipation plate is provided with a mounting boss that extends into each of the through holes, each of the screw holes is located in a middle of the mounting boss, the mounting boss is positioned to extend into each of the through holes when the heat dissipation plate, the middle housing plate, the circuit board, and the support plate are fixed, the screws pass through the mounting holes and threadedly connect with the screw holes on the mounting boss, and causes the middle housing plate to be clamped and fixed between the heat dissipation plate and the support plate.

7. The impact-resistant rearview mirror according to claim 5, further comprising a circuit board installed between the middle housing plate and the support plate, the circuit board is provided with an opening corresponding to a position of each of the through holes, the middle housing plate is recessed backward at a position corresponding to each of the mounting holes and is provided with a spacing ring around a recessed position, thereby forming a positioning groove on a front side of the middle housing plate, and forming a spacing boss on a rear side of the middle housing plate, each of the through hole is provided at a bottom of each of the positioning grooves, a rear side surface of the heat dissipation plate is provided with a positioning boss that extends into each of the positioning grooves and a mounting boss that is provided on the positioning boss and extends into each of the through holes and the opening, each of the screw holes is located in a middle of the mounting boss, the positioning boss of the heat dissipation plate is positioned to extend into each of the positioning grooves and the mounting boss is positioned to extend into each of the through holes and the opening when the heat dissipation plate, the middle housing plate, the circuit board, and the support plate are fixed, and a surface of the spacing boss abuts against the circuit board so that a plate surface of the middle housing plate and the circuit board are spaced apart, the plate surface of the heat dissipation plate abuts against the spacing ring so that the plate surface of the heat dissipation plate and the plate surface of the middle housing plate are spaced apart, the screws pass through the mounting holes and threadedly connect with the screw holes on the mounting boss, and causes the middle housing plate and the circuit board to be clamped and fixed between the heat dissipation plate and the support plate.

8. The impact-resistant rearview mirror according to claim 2, wherein the middle housing plate comprises a middle portion located at a transverse middle position of the housing, an edge portion connected to front housing side walls on left and right sides of the front housing, and a reinforcement portion spaced between the middle portion and the edge portion, upper and lower sides of the middle portion and the reinforcement portion are respectively connected to front housing side walls on upper and lower sides of the front housing, a heat dissipation space is formed between the edge portion and the reinforcement portion, and a heat dissipation space is formed between the reinforcement portion and the middle portion.

9. The impact-resistant rearview mirror according to claim 3, wherein a front side of the front housing forms an opening configured to allow the display module to pass through, the display module passes through the opening and is installed in the housing, the reflective mirror is installed on the mounting platform to seal the opening.

10. The impact-resistant rearview mirror according to claim 1, wherein the adhesive layer is an optically clear adhesive, OCA, cured layer or an optically clear resin, OCR, cured layer.

11. The impact-resistant rearview mirror according to claim 1, wherein a front end of the base is provided with a universal ball, the universal ball is pivotally connected to the support plate, the universal ball is universally connected to the support plate and supports the support plate.

12. The impact-resistant rearview mirror according to claim 1, wherein the base is installed on a vehicle windshield and passes through the rear housing to be supportingly connected to the support plate.

13. The impact-resistant rearview mirror according to claim 1, wherein the display module comprises a heat dissipation plate, a backlight unit, an optical unit, and a display screen, the heat dissipation plate is provided with an installation cavity, the backlight unit and the optical unit are installed in the installation cavity of the heat dissipation plate.

14. The impact-resistant rearview mirror according to claim 3, wherein an inner side of the mounting platform is recessed in a step shape, a foam adhesive is provided at a recessed step, the reflective mirror is pasted on the mounting platform via the foam adhesive.

15. The impact-resistant rearview mirror according to claim 8, wherein the reinforcement portion is provided with a plurality of reinforcement ribs protruding therefrom.
